# EUROPEAN PATENT SPECIFICATION

(11) **EP 2 844 102 B1**
(45) Date of publication and mention of the grant of the patent: **27.02.2019**
(21) Application number: 13719178.9
(22) Date of filing: 30.04.2013
(51) Int. Cl.: A45D 1/04, A45D 1/06, A45D 2/00

(54) **HAIR STYLING APPLIANCE**
HAARSTYLINGVORRICHTUNG
DISPOSITIF DE COIFFURE

(30) Priority: 01.05.2012 GB 201207549
(43) Date of publication of application: 11.03.2015
(73) Proprietor: Jemella Limited, Leeds Yorkshire LS11 5BZ (GB)
(72) Inventor: MOORE, Tim, Royston Hertfordshire SG8 7XP (GB); GAGIANO, Mark Andrew, Piara Waters WA 6112 (AU)
(74) Representative: MacDougall, Alan John Shaw
(86) International application number: PCT/GB2013/051099
(87) International publication number: WO 2013/164594

(56) References cited:
- WO-A1-2009/123424
- WO-A1-2009/123424
- US-A1- 2010 147 323
- US-A1- 2010 147 323

## Description

### FIELD OF THE INVENTION

The invention relates to hair styling apparatus, in particular those for straightening hair.

### BACKGROUND TO THE INVENTION

There are a variety of apparatus available for styling hair. One form of apparatus is known as a straightener which employs plates that are heatable. To style, hair is clamped between the plates and heated above a transition temperature where it becomes mouldable. Depending on the type, thickness, condition and quantity of hair, the transition temperature may be in the range of 160-200°C.

A hair styling appliance can be employed to straighten, curl and/or crimp hair.

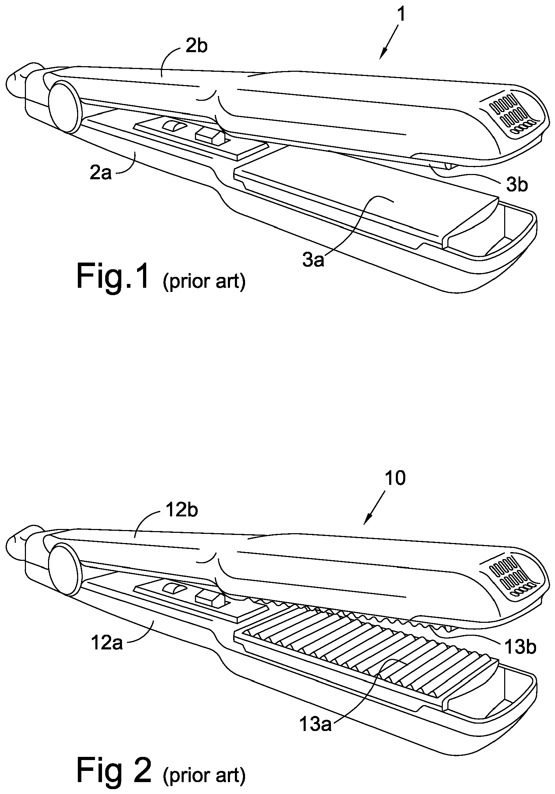

A hair styling appliance for straightening hair is commonly referred to as a "straightening iron" or "hair straightener". Figure 1 depicts an example of a typical hair straightener 1. The hair straightener 1 includes first and second arms 2a, 2b each comprising heatable plates 3a, 3b coupled to heaters (not shown) in thermal contact with the heatable plates. The heatable plates are substantially flat and are arranged on the inside surfaces of the arms in an opposing formation. During the straightening process, hair is clamped between the hot heatable plates and then pulled under tension through the plates so as to mould it into a straightened form. The hair straightener may also be used to curl hair by rotating the hair straightener 180° towards the head prior to pulling the hair through the hot heatable plates.

Ceramic heaters, in particular those with a pure resistive profile enable optimisation of the thermal control loop, thus allowing the plates in contact with hair to remain near transition temperature during styling and thermal load application. This leads to longevity of style.

A hair styling appliance for crimping hair is commonly referred to as a "crimping iron".

Figure 2 depicts an example of a typical crimping iron 10. The crimping iron includes first and second arms 12a and 12b. Each arm comprises a heatable plate 13a, 13b coupled to heaters (not shown) in thermal contact with the heatable plates. The heating plates have a saw tooth (corrugated, ribbed) surface and are arranged on the inside surfaces of the arms in an opposing formation. During the crimping process, the hair is clamped between the hot heatable plates until it is moulded into a crimped shape.

In the process of clamping hair between the plates, hair may be pushed off the end of the heating plates as the arms are clamped over the hair, meaning the arms need to be released and the section of hair reclamped. This can lead to the styling process taking longer. To overcome this problem, one approach has been to arrange the arms and plates such that they are angled towards one another to a point at the ends of the plates, meaning that as a section of hair is clamped the endpoints provide a barrier to escaping hair.

In order to maintain effective styling, it is desirable that the plates also retain an even clamping force across the section of hair between the plates during the styling process. In some conventional devices, the arms of the styling appliance may flex when squeezed by a user. This helps to realign the plates with a section of hair now clamped. However it may be hard for a user to apply such a squeezing pressure for anything but a short period of time. Furthermore, by requiring such a flex in the arms, the choice of materials, and construction of the styling appliance is limited. The applicant has recognised a need to improve existing hair styling appliances to address these problems. US20100147323 describe a hair styling device. WO2009123424 describes a hair curling iron.

### SUMMARY OF THE INVENTION

Aspects and preferred features are set out in the accompanying claims.

We disclose herein a hair styling apparatus as described in claim 1.

The hair styling apparatus may be a hair straightener or hair crimper for example. Such an apparatus provides a pivot about which the heatable plates can move in a "seesaw" type action (for example) between opposing sides of the plates (one end nearest the jaw, the other nearest the arm coupling).

The fact that one or both of the plates "seesaws" is beneficial over conventional forms of plate that may flex solely on a cushioning or suspension as it avoids any pressure differential across the plates. This means that ceramic heaters coupled to the underside of the plates are also not put under any undue stress and so reduces the risk of cracking and leads to an increase in lifetime.

This ensures good thermal contact with the hair as the appliance is moved. It will be appreciated that one or both of the arms may have a plate pivot, with the heatable plate on each arm moving about the pivot on the respective arm. In embodiments where both heatable plates are pivotable each heatable plate needs to move less, compared to a single pivoting plate, in order to achieve the same degree of relative rotation between each of the heatable plates.

Conventionally a user exerts a closing force on the arms which leads to the arms flexing and rotating the plates relative to one another. By providing a pivot about which the heatable plate(s) move/rotate (the plate pivot), the closing force needing to be applied by a user is reduced, making the apparatus easier to hold and use for styling. Furthermore, this also increases the construction options available, allowing use of different materials that may not flex as well or as reliably.

The plate pivot is configured to permit an end of the heatable plate of at least one arm furthest from the coupled ends of the arms to contact the heatable plate of the other arm first when moved from the open position to the closed position. Thus, in this arrangement, the plates are biased such that when the plates move from an open to closed position, the heatable plates then first abut one another at the mouth end of the hair styler, i.e. at the end of at least one of the heatable plates furthest from the coupled end of the arms. In embodiments adopting such an arrangement, the heatable plates are then angled towards one another in the closed position as they first touch such that hair can be prevented from escaping, or falling off the end.

Further closing of the arms, for example by squeezing the arms together, may then rotate one or both of the heatable plates about its plate pivot such that the heatable plates are then able to abut flat against one another as the arms converge towards one another at their distal end. With such an additional squeezing force applied, hair to be styling is more forceably held within between the heater plates.

The plate pivot may be in a variety of positions along the heatable plate and in embodiments is may be spaced away from the end of the at least one heatable plate furthest from the coupled ends of the arms. In some embodiments the pivot may be positioned at an equal distance between ends of the heatable plate furthest from the coupled end of the arms and closest to the coupled end of the arms.. In other variants the pivot may be at the end of the heatable plate closest to or furthest away from the coupled end of the arms. These variants allow may allow the degree of rotation to vary, depending on the particular construction and dimensions of the arm in which the heatable plate is mounted.

In some embodiments, this arm coupling may permit the arms to pivot relative to another other through the use of an arm pivot. In other embodiments, the arms may be formed from a continuous material or chassis, extending through a shoulder region that curves to allow the two arms to oppose one another. In such an embodiment, the arms are in effect coupled by a shoulder region that may be integrally formed with the arms. The shoulder/coupling may flex. Alternatively the shoulder may be rigid and coupled to the arms by a flexible/bendable/moveable regional allow relative movement of the arms.

In some embodiments the arms may be biased apart, enabling a user to clamp the heatable plates around a quantity of hair, straighten the hair, and then allow the arms to separate automatically as the hair clamping is relaxed.

The plate pivot may comprise a projection on one of the heatable plates or the respective arm member. This may then engage with a slot (or groove) on the other of the heatable plate / respective arm member, which receives the projection - it may snap fit into the slot for example to allow the plates to rotate about the plate pivot.

In one or both of the arms, the heatable plate coupled about the plate pivot may be biased parallel to the respective arm member of the heatable plate on the arm. This parallel biasing may preferably be when then arms are in the open position and thus when no pressure is applied to the heatable plate, thereby allowing a user to easily position / slide a quantity of hair between the plates.

The fact that at least one of the plates can rotate/move about a plate pivot means that the plates may be moveable to a generally parallel arrangement allowing a uniform clamping force to be applied. Therefore, in use, the at least one heatable plate may then move about the pivot responsive to clamping the arms about a quantity of hair. When the ends of the plates first abut one another, and as the clamping force is increased, the opportunity for hair to escape from the ends of the plates is reduced due to the increased pressure applied by a user. This means any opening formed at the ends of the plates does not lead to hair escaping.

In embodiments in which both arms comprise a plate pivot, both of the heatable plates may be moveable relative to their respective arm members about an axis transverse to the length of each of said respective arm members. In such variants any of the previously described features may be used. It is not necessary in such embodiments for both plate pivots to be positioned at the same point along each heater plate. The presence of two pivoting plates allows the plate pivot on the first arm and the plate pivot on the second arm to be positioned at different positions along the respective coupled heatable plate.

As it is important to ensure good thermal contact with the hair, at least one of the pivots may be supported on a resilient suspension to allow some sideways movement of each contacting surface relative to its arm. This further improves the contact between the hair and the heatable plates whilst still retaining the pivoting action. In some embodiments one or both pivots are supported on a resilient suspension.

Each arm may be generally elongate and with the heatable plates extending along at least part of the length of each of the respective arm members.

The heatable plates may be in thermal contact with a respective heater in the hair styling apparatus, such as an electric heating element.

The heatable plates may also be generally planar to provide a flat surface for straightening hair.

The heatable plates, in use, may heat a section of hair clamped between the heatable plates to at least 160°C.

The hair styling apparatus may further comprise a control system configured to control the operation of the heaters, which may interact with a temperature sensor for example, to control activation of the heaters or alert a user when the desired styling temperature (at least 160°C for example) has been reached.

We disclose herein a hair styling apparatus comprising a pair of arms, the arms having a first pivot at one end and being pivotable to close at an opposite end, at least one of the arms having a heatable plate at the opposite end, and wherein the heatable plate is mounted on a second pivot having an axis aligned with the first pivot, to enable the heatable plate to pivot as the arms are closed.

In the hair styling apparatus each arm may have a heatable plate with a respective second pivot. The plates may touch towards the opposite end as the arms close. In use, further closing of the arms rotates the heatable plates about their respective second pivots such that the heatable plates are able to abut flat against one another whilst the arms converge towards the opposite end.

Advantageously the heatable plates define a very flat, smooth surface. On the inner surface to which the heater is attached this helps to provide good thermal contact with the heater; on the outer surface it helps to provide a smooth surface, reducing friction with the hair to be styled.

We disclose herein a method of manufacturing a heater assembly for a hair styling appliance, the method comprising: providing a metal heat transfer element; shaping said metal heat transfer element by cold forging; milling flat at least one surface of said cold forged metal heat transfer element; and adding a heater to a surface of said metal heat transfer element.

In embodiments a first ("inner") surface of the metal heat transfer element (plate) is milled flat and the heater is provided on this surface. Additionally or alternatively just the "outer" surface, which interacts with the hair, is milled flat. In preferred embodiments, however, two opposite surfaces of the cold forged metal heat transfer element are milled flat. In embodiments the work hardening from the cold forging process can assist in achieving a smooth surface for improved heat transfer/reduced hair friction.

In embodiments the metal heat transfer element comprises an aluminium plate and the heater comprises a ceramic layer on the aluminium plate bearing an electrically conducting heating element. In preferred embodiments the heater is a single-sided ceramic heater, comprising a ceramic layer with an electrical conducting element on one face, a second opposite face of said ceramic layer being mounted on and in thermal contact with a face of a heating layer, and wherein said ceramic layer lacks a heating layer on said first face. In embodiments the cold forging comprises a stamp and bend process leaving said metal heat transfer element with curved edges.

### BRIEF DESCRIPTION OF THE DRAWINGS

For a better understanding of the invention and to show how it may be carried into effect reference shall now be made, by way of example only, to the accompanying drawings in which:
Fig. 1 shows an example of hair straighteners according to the prior art;
Fig. 2 shows an example of hair crimpers according to the prior art;
Fig. 3a shows an example of hair straighteners with pivotable plates;
Fig. 3b shows the staighteners of Fig. 3a in a first closed position;
Fig. 3c shows the staighteners of Fig. 3a in a second position with hair clamped between the plates;
Fig.4 shows a variant of the pivotable plates of Fig. 3a;
Fig. 5 shows a further variant of the pivotable plates of Fig. 3a;
Fig.6 shows a further variant of the pivotable plates combining the plate of Fig. 4 and 5; and
Fig. 7 schematically, a vertical cross-section through a heater plate.

### DETAILED DESCRIPTION OF THE PREFFERED EMBODIMENTS

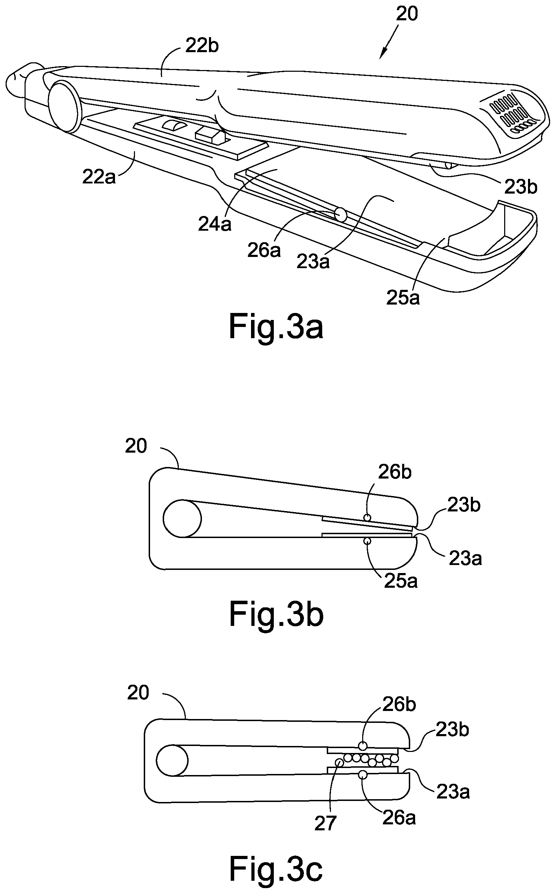

Referring now to Figure 3a, this shows an example embodiment of a hair styling apparatus 20 (in this example a hair straightener) with a pair of arms 22a, 22b and heatable plates 23a and 23b.

Heatable plate 23 is mounted to a pivot 26a (plate pivot) to allow the heatable plate to rotate about the pivot. In Figure 3a plate 23a is shown angled downwards, with end 25a furthest away from the arm coupling below the pivot point and arm 24a above the pivot point. The heatable plate can rotate from this shown position to a second position in which end 25a is raised above the pivot point and end 24a falls below the pivot point. Plate 23b may similarly rotate about another pivot on arm 22b (not shown).

Figure 3b shows the hair styler with both arms closed together. When closed, the arms are off-parallel, forming an acute angle between plates 23a and 23b meaning that the plates are also not parallel if they are biased by default parallel with their respective arm. Thus, the plates are biased such that when the plates move from an open to closed position, the heatable plates then first abut one another at the mouth end of the hair styler, i.e. at the end of at least one of the heatable plates furthest from the arm coupling which connects the two arms of the hair styler together. This means that, in the closed position as the plates first touch, the ends of the heatable plates further from the arm coupling are closer to one another than the ends of the heatable plates closest to the arm coupling. Such an arrangement may be further used, for example, to enable the arms to first abut one other at the mouth end of the arm, i.e. the end furthest away from the arm coupling.

This arrangement is useful for ensuring that hair does not fall or get pushed off the end of the plates as pressure is applied to the hair.

With a further squeezing pressure applied to the arms of the hair styler after the plates first touch, the plates then pivot further, as depicted in Figure 3c. Figure 3c shows a quantity of hair 27 clamped between the plates by a user squeezing arms 23a and 23b together. In this example, the quantity of hair is slightly thicker at the end of the plates furthest away from the coupling end of the arms. Plates 23a and 23b can be seen to pivot about pivots 26a and 26b respectively to retain contact and a good grip on the hair along the length of the heatable plates.

In the embodiment in Figure 3a the pivot is positioned at an equal distance between ends 24a and 25a of the plates. This arrangement allows the plates to first abut one another at the end of the plates furthest from the arm coupling when moved to the closed position, thereby preventing hair falling off the end of the plates. Further, in the example shown, the pivot 26a is provided by a projections extending sidewards from either side of plate 23a which engages with slots either side of plate 23a moulded into arm 22a. Such projections may be part of a heating plate assembly / housing to which the metal plate 23a is mounted. In variants it will be appreciated that slots may be provided on the plate / plate housing or assembly and the projections on the arm either side of the plates. Other examples of pivots are possible, for example, the pivot may be positioned below the plate, engaging with the plate / plate housing / assembly below the plate.

One or both of heatable plates 23a and 23b are biased parallel to their respective arms 22a and 22b such that when in use and the styler is applied to hair or released, there is no risk of hair getting caught across any end of the plates.

Plate pivot 26a may be mounted on a resilient suspension to allow sideways movement of plate 23a relative to the arm which helps the plate retain contact with hair clamped as a user moves the styler during styling. The same applies to plate 23b.

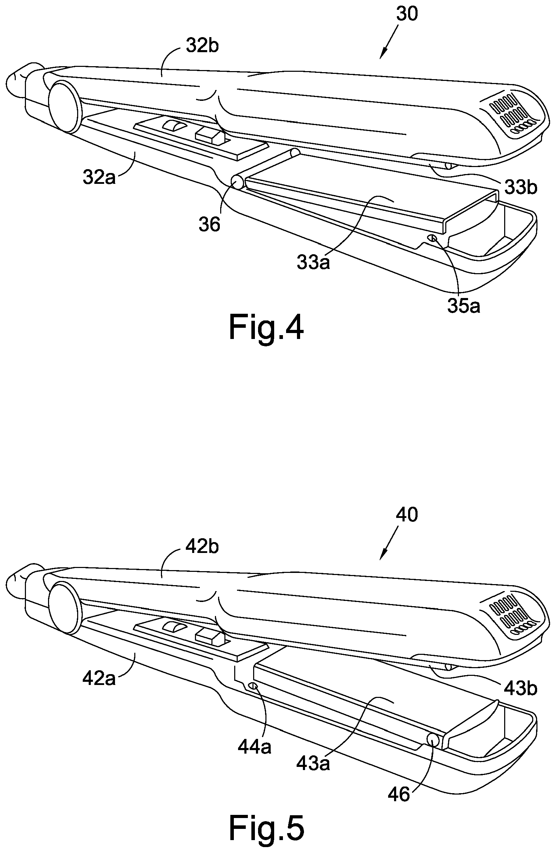

A variant of the Figure 3a embodiment is shown in Figure 4. In this variant, the hair straightener 30 comprises heatable plates 33a and 33b. Plate 33a is pivoted about plate pivot 36 positioned at the end of the plate closest to the arm coupling such that plate end 35a rotates. The plates are biased such that when the plates move from an open to closed position, the heatable plates again first abut one another at the mouth end of the hair styler, i.e. at the end of at the heatable plates furthest from the arm coupling which connects the two arms of the hair styler together. Thus, in the closed position, the ends of the heatable plates furthest from the arm coupling are closer to one another than the ends of the heatable plates closest to the arm coupling.

In the variant shown in Figure 5, hair straightener 40 comprises heatable plates 43a and 43b. Plate 43a is pivoted about pivot point 46 positioned at the end of the plate furthest away from the arm coupling such that end 44a rotates.

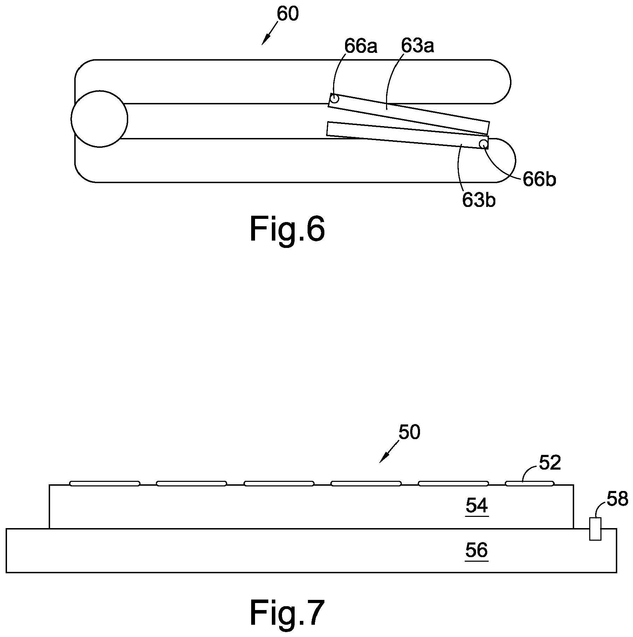

In the embodiments described in Figures 3a-c, 4 and 5, it is not necessary for the pivot to be in the same position on both heater plates. In variants, for example, a combination of the arrangements in Figures 4 and 5 may be used, as shown in Figure 6. In this arrangement one heater plate 63a is pivoted at an end closest to the arm coupling, by pivot 66a, and the other heater plate 63b is pivoted at the end of the arm, by plate pivot 66b, furthest from the arm coupling. The plates are biased such that when they move from the open to closed position, they first abut one another at the mouth end of the hair styler as shown in Figure 6. In such an arrangement, when closed, the ends of the heatable plates furthest from the arm coupling are again closer to one another than the ends of the heatable plates closest to the arm coupling (as depicted in Figure 6). The heater plates are then relatively biased such that they first abut at the end of the heater plate furthest from the arm coupling. To achieve this an end of the heater plate 63a biased according to Figure 4 is arranged such that its other end (the mouth end) projects further towards the opposing arm than the arm coupling end of the other arm. The resulting effect is that when moving to the closed position, the arms then first abut one other at the mouth end of the arm, i.e. the end furthest away from the arm coupling.

Referring now to Figure 7, this shows a single-sided ceramic heater 50 comprising a metal, for example aluminium, heating plate 56 bearing a layer of ceramic 54, for example an oxide layer, on which is deposited an electrically conductive pattern 52 forming a heating element. The heating plate may incorporate a temperature sensor 58 such as a thermistor or thermocouple; alternatively the temperature sensor may be located elsewhere.

To further improve contact with hair, the heatable plate 56 may be cold forged then milled, to provide a very flat surface. The plate may be formed by shaping the metal plate, (for example by stamping then bending), followed by milling to provide the flat surface. Milling may also be used to flatten a screw boss, or any other securing feature used to hold the plate to the heater and any form of substrate / enclosure.

Such a process may be applied to one or both sides of the heatable plate 56 to improve thermal contact with one or both of the ceramic heater 54 used to heat the plate and hair in contact with the heatable plate 56 during styling.

It will be understood that one or both of the heatable plates may pivot, and the examples shown in attached figures shown only one heatable plate being able to rotate for simplicity.

Through out the description and claims of this specification, the words "comprise" and "contain" and variations of the words, for example "comprising" and "comprise", means "including but not limited to, and is not intended to (and does not) exclude other moieties, additives, components, integers or steps.

## Claims

1. A hair styling apparatus (20) comprising
a first and a second arm (22a, 22b) coupled at one end, and each comprising a heatable plate (23a, 23b) and arm member,
wherein the first and second arms are moveable between a closed position in which said heatable plate of said first arm is adjacent said heatable plate of said second arm and an open position in which said heatable plates of the first and second arms are spaced apart, and
wherein said heatable plate of at least one of said arms is coupled to a respective arm member by means of a plate pivot (26a) arranged to allow said heatable plate to move relative to said respective arm member about an axis transverse to the length of said respective arm member,
**characterised in that** said heatable plate of said at least one arm is biased to cause an end of said heatable plate of said at least one arm furthest from said coupled ends of said arms, to contact said heatable plate of said other arm first when moved from said open position to said closed position.

2. A hair styling apparatus as claimed in claim 1, wherein said plate pivot (26a) is spaced away from said end of said at least one heatable plate furthest from said coupled ends of said arms.

3. A hair styling apparatus as claimed in claim 2, wherein:
said plate pivot (26a) is positioned at an equal distance between ends of said at least one heatable plate furthest from said coupling end of said arms and closest to said coupled end of said arms; or
said plate pivot is positioned at an end of said at least one heatable plate closest to said coupled end of said arms; or
said plate pivot is positioned at an end of said at least one heatable plate furthest from said coupled end of said arms.

4. A hair styling apparatus as claimed in any preceding claim, wherein, in use, further closing of said arms rotates said at least one heatable plate about its plate pivot such that said heatable plates are able to abut flat against one another whilst said arms converge towards said distal end.

5. A hair styling apparatus as claimed in any preceding claim, further comprising an arm coupling arranged to pivotably couple said first and second arms to one another; and/or
wherein said heatable plate is biased parallel to said respective arm member when in said open position.

6. A hair styling apparatus as claimed in any preceding claim wherein:
said plate pivot comprises a projection on one of said heatable plates or said respective arm member and a slot to receive said projection on the other of said heatable plate or said respective arm member.

7. A hair styling apparatus as claimed in any preceding claim wherein said pivot is supported on a resilient suspension.

8. A hair styling apparatus as claimed in any preceding claim, wherein, in use, said at least one heatable plate is arranged to move about said pivot responsive to clamping said first and second arms about a quantity of hair; and/or wherein each said arm is generally elongate and said heating plates extend along at least part of the length of each of said respective arm members.

9. A hair styling apparatus as claimed in any preceding claim, further comprising a said pivot on both of said arms, and wherein both said heatable plates are moveable relative to said respective arm members about an axis transverse to the length of each of said respective arm members.

10. A hair styling apparatus as claimed in any preceding claim, wherein said heatable plates are each in thermal contact with a respective heater in the hair styling apparatus.

11. A hair styling apparatus as claimed in any preceding claim, wherein, in use, the heatable plates heat a section of hair clamped between the heatable plates to at least 160°C.

12. A hair styling apparatus as claimed in claim 10 or 11, further comprising a control system configured to control operation of said heaters.

13. A hair styling apparatus as claimed in any preceding claim, wherein said heatable plates are generally planar.

14. A hair styling apparatus as claimed in any preceding claim, wherein said hair styling appliance is a hair straightener.

15. A hair styling apparatus as claimed in any one of claims 1 to 13, wherein said hair styling appliance is a hair crimper.

## Patentansprüche

1. Hairstyling-Vorrichtung (20), die Folgendes umfasst:
einen ersten und einen zweiten Arm (22a, 22b), die an einem Ende gekoppelt sind und jeweils eine heizbare Platte (23a, 23b) und ein Armelement umfassen,
wobei der erste und zweite Arm zwischen einer geschlossenen Position, in der sich die genannte heizbare Platte des genannten ersten Arms neben der genannten heizbaren Platte des genannten zweiten Arms befindet, und einer offenen Position beweglich sind, in der die genannten heizbaren Platten des ersten und zweiten Arms beabstandet sind, und
wobei die genannte heizbare Platte von wenigstens einem der genannten Arme mit einem jeweiligen Armelement mittels einem Plattendrehpunkt (26a) gekoppelt ist, der so ausgelegt ist, dass er eine Bewegung der genannten heizbaren Platte relativ zu dem genannten jeweiligen Armelement um eine Achse transversal zur Länge des genannten jeweiligen Armelements zulässt,
**dadurch gekennzeichnet, dass** die genannte heizbare Platte des genannten wenigstens einen Arms vorgespannt ist, um zu bewirken, dass ein Ende der genannten heizbaren Platte des genannten wenigstens einen Arms, der am weitesten von den genannten gekoppelten Enden der genannten Arme entfernt ist, die genannte Heizplatte des genannten anderen Arms zuerst kontaktiert, wenn sie von der genannten offenen Position in die genannte geschlossene Position bewegt wird.

2. Hairstyling-Vorrichtung nach Anspruch 1, wobei der genannte Plattendrehpunkt (26a) von dem genannten Ende der genannten wenigstens einen Heizplatte beabstandet ist, das am weitesten von den genannten gekoppelten Enden der genannten Arme entfernt ist.

3. Hairstyling-Vorrichtung nach Anspruch 2, wobei:
der genannte Plattendrehpunkt (26a) in einem gleichen Abstand zwischen Enden der genannten wenigstens einen heizbaren Platte positioniert ist, die am weitesten von dem genannten Kopplungsende der genannten Arme entfernt ist und dem genannten gekoppelten Ende der genannten Arme am nächsten liegt; oder
der genannte Plattendrehpunkt an einem Ende der genannten wenigstens einen Heizplatte positioniert ist, die dem genannten gekoppelten Ende der genannten Arme am nächsten liegt; oder
der genannte Plattendrehpunkt an einem Ende der genannten wenigstens einen Heizplatte positioniert ist, das am weitesten von dem genannten gekoppelten Ende der genannten Arme entfernt ist.

4. Hairstyling-Vorrichtung nach einem vorherigen Anspruch, wobei beim Gebrauch ein weiteres Schließen der genannten Arme die genannte wenigstens eine heizbare Platte um ihren Plattendrehpunkt dreht, so dass die genannten heizbaren Platten flach aneinander anliegen können, während die genannten Arme in Richtung des genannten distalen Endes konvergieren.

5. Hairstyling-Vorrichtung nach einem vorherigen Anspruch, die ferner eine Armkupplung umfasst, die zum drehbaren Koppeln des genannten ersten und zweiten Arms miteinander ausgelegt ist; und/oder
wobei die genannte heizbare Platte parallel zu dem genannten jeweiligen Armelement vorgespannt ist, wenn sie in der genannten offenen Position ist.

6. Hairstyling-Vorrichtung nach einem vorherigen Anspruch, wobei:
der genannte Plattendrehpunkt einen Vorsprung an einer der genannten heizbaren Platten oder dem genannten jeweiligen Armelement und einen Schlitz zum Aufnehmen des genannten Vorsprungs an dem anderen aus der genannten Heizplatte oder dem genannten jeweiligen Armelement umfasst.

7. Hairstyling-Vorrichtung nach einem vorherigen Anspruch, wobei der genannte Drehpunkt auf einer elastischen Aufhängung getragen wird.

8. Hairstyling-Vorrichtung nach einem vorherigen Anspruch, wobei beim Gebrauch die genannte wenigstens eine heizbare Platte zum Bewegen um den genannten Drehpunkt als Reaktion auf ein Klemmen des genannten ersten und zweiten Arms um eine Haarmenge herum ausgelegt ist; und/oder wobei jeder genannte Arm allgemein länglich ist und die genannten Heizplatten entlang wenigstens einem Teil der Länge jedes der genannten jeweiligen Armelemente verlaufen.

9. Hairstyling-Vorrichtung nach einem vorherigen Anspruch, die ferner einen genannten Drehpunkt an beiden genannten Armen umfasst, und wobei beide genannten heizbaren Platten relativ zu den genannten jeweiligen Armelementen um eine Achse transversal zur Länge jedes der genannten jeweiligen Armelemente beweglich sind.

10. Hairstyling-Vorrichtung nach einem vorherigen Anspruch, wobei die genannten heizbaren Platten jeweils in Wärmekontakt mit einer jeweiligen Heizung in der Hairstyling-Vorrichtung sind.

11. Hairstyling-Vorrichtung nach einem vorherigen Anspruch, wobei beim Gebrauch die heizbaren Platten einen Abschnittt von zwischen den heizbaren Platten geklemmten Haaren auf wenigstens 160°C erhitzen.

12. Hairstyling-Vorrichtung nach Anspruch 10 oder 11, die ferner ein Steuersystem umfasst, konfiguriert zum Steuern des Betriebs der genannten Heizungen.

13. Hairstyling-Vorrichtung nach einem vorherigen Anspruch, wobei die genannten heizbaren Platte allgemein planar sind.

14. Hairstyling-Vorrichtung nach einem vorherigen Anspruch, wobei die genannte Hairstyling-Vorrichtung ein Haarglätter ist.

15. Hairstyling-Vorrichtung nach einem der Ansprüche 1 bis 13, wobei die genannte Hairstyling-Vorrichtung ein Haarkräuseler ist.

## Revendications

1. Appareil de coiffure (20), comprenant :
un premier et un second bras (22a, 22b) accouplés à une extrémité, et comprenant chacun une plaque chauffante (23a, 23b) et un élément de bras,
les premier et second bras étant mobiles entre une position fermée dans laquelle ladite plaque chauffante dudit premier bras est adjacente à ladite plaque chauffante dudit second bras, et une position ouverte dans laquelle lesdites plaques chauffantes des premier et second bras sont espacées, et
ladite plaque chauffante d'au moins un desdits bras étant accouplée à un élément de bras respectif au moyen d'un pivot de plaque (26a) conçu pour permettre à ladite plaque chauffante de se déplacer par rapport audit élément de bras respectif autour d'un axe transversal à la longueur dudit élément de bras respectif,
l'appareil de coiffure étant **caractérisé en ce que** ladite plaque chauffante dudit au moins un bras est sollicitée pour amener une extrémité de ladite plaque chauffante dudit au moins un bras la plus éloignée desdites extrémités accouplées desdits bras à entrer en contact en premier avec ladite plaque chauffante dudit autre bras lorsqu'ils sont déplacés de ladite position ouverte à ladite position fermée.

2. Appareil de coiffure selon la revendication 1, dans lequel ledit pivot de plaque (26a) est espacé de ladite extrémité de ladite au moins une plaque chauffante la plus éloignée desdites extrémités accouplées desdits bras.

3. Appareil de coiffure selon la revendication 2, dans lequel :
ledit pivot de plaque (26a) est positionné à équidistance entre des extrémités de ladite au moins une plaque chauffante les plus éloignées de ladite extrémité d'accouplement desdits bras et les plus proches de ladite extrémité accouplée desdits bras ; ou
ledit pivot de plaque est positionné au niveau d'une extrémité de ladite au moins une plaque chauffante la plus proche de ladite extrémité accouplée desdits bras ; ou
ledit pivot de plaque est positionné au niveau d'une extrémité de ladite au moins une plaque chauffante la plus éloignée de ladite extrémité accouplée desdits bras.

4. Appareil de coiffure selon l'une quelconque des revendications précédentes, dans lequel, lors de l'utilisation, un rapprochement supplémentaire desdits bras fait tourner ladite au moins une plaque chauffante autour de son pivot de plaque de sorte que lesdites plaques chauffantes puissent venir en butée à plat l'une contre l'autre pendant que lesdits bras convergent vers ladite extrémité distale.

5. Appareil de coiffure selon l'une quelconque des revendications précédentes, comprenant en outre un accouplement de bras conçu pour accoupler en pivotement lesdits premier et second bras l'un à l'autre ; et/ou
dans lequel ladite plaque chauffante est sollicitée parallèlement audit élément de bras respectif quand celui-ci est dans ladite position ouverte.

6. Appareil de coiffure selon l'une quelconque des revendications précédentes, dans lequel :
ledit pivot de plaque comprend une protubérance sur une desdites plaques chauffantes ou sur ledit élément de bras respectif, ainsi qu'une rainure pour recevoir ladite protubérance sur l'autre desdites plaques chauffantes ou sur ledit élément de bras respectif.

7. Appareil de coiffure selon l'une quelconque des revendications précédentes, dans lequel ledit pivot est supporté sur une suspension élastique.

8. Appareil de coiffure selon l'une quelconque des revendications précédentes, dans lequel, lors de l'utilisation, ladite au moins une plaque chauffante est conçue pour se déplacer autour dudit pivot en réponse au pinçage desdits premier et second bras autour d'une quantité de cheveux ; et/ou dans lequel chaque bras est généralement allongé et lesdites plaques chauffantes s'étendent le long, au moins en partie, de la longueur de chacun desdits éléments de bras respectifs.

9. Appareil de coiffure selon l'une quelconque des revendications précédentes, comprenant en outre un tel pivot sur deux desdits bras, et dans lequel lesdites plaques chauffantes sont l'une et l'autre mobiles par rapport auxdits éléments de bras respectifs autour d'un axe transversal à la longueur de chacun desdits éléments de bras respectifs.

10. Appareil de coiffure selon l'une quelconque des revendications précédentes, dans lequel lesdites plaques chauffantes sont chacune en contact thermique avec un élément chauffant respectif dans l'appareil de coiffure.

11. Appareil de coiffure selon l'une quelconque des revendications précédentes, dans lequel, lors de l'utilisation, les plaques chauffantes chauffent une section de cheveux pincés entre les plaques chauffantes à au moins 160 °C.

12. Appareil de coiffure selon la revendication 10 ou 11, comprenant en outre un système de commande configuré pour commander le fonctionnement desdits éléments chauffants.

13. Appareil de coiffure selon l'une quelconque des revendications précédentes, dans lequel lesdites plaques chauffantes sont généralement planes.

14. Appareil de coiffure selon l'une quelconque des revendications précédentes, ledit appareil de coiffure étant un lisseur à cheveux.

15. Appareil de coiffure selon l'une quelconque des revendications 1 à 13, ledit appareil de coiffure étant une gaufreuse à cheveux.
